## Europäisches Patentamt

## European Patent Office

## Office européen des brevets

(19)

(11) Veröffentlichungsnummer: **0 362 931**
**A2**

(12) **EUROPÄISCHE PATENTANMELDUNG**

(21) Anmeldenummer: **89202425.8**

(22) Anmeldetag: **27.09.89**

(51) Int. Cl.⁵: **G01R 33/38**

(30) Priorität: **03.10.88 DE 3833591**

(43) Veröffentlichungstag der Anmeldung:
**11.04.90 Patentblatt 90/15**

(84) Benannte Vertragsstaaten:
**DE FR GB NL**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB NL**

(72) Erfinder: **Alich, Thomas**
**Hermelinweg 14a**
**D-2200 Elmshorn(DE)**
Erfinder: **Flisikowski, Peter**
**Joachim-Mähl-Strasse 1a**
**D-2000 Hamburg 61(DE)**
Erfinder: **Peemöller, Horst**
**Bengelsdorfstrasse 2**
**D-2000 Hamburg 71(DE)**

(74) Vertreter: **Kupfermann, Fritz-Joachim,**
**Dipl.-Ing. et al**
**Philips Patentverwaltung GmbH**
**Wendenstrasse 35 Postfach 10 51 49**
**D-2000 Hamburg 1(DE)**

(54) **Vorrichtung zum Anordnen von Gradientenspulen in einem homogenen Feld.**

(57) Die Erfindung bezieht sich auf eine Vorrichtung zum Anordnen von Gradientenspulen (4) im homogenen Feld des Magneten (7) eines MR-Tomographiegerätes mit einem Spulenrohr (5), an dessen Wand die Gradientenspulen (4) befestigt sind, wobei das Spulenrohr (5) mit den Gradientenspulen (4) ohne Abstützung innerhalb des Magneten (7) angeordnet ist und von einem Trägerrohr (1) getragen wird, das sich außerhalb des Magneten (7) befindet, und justierbar von einem Traggestell (3) getragen wird.

Fig.1

## Vorrichtung zum Anordnen von Gradientenspulen in einem homogenen Feld

Die Erfindung bezieht sich auf eine Vorrichtung zum Anordnen von Gradientenspulen im homogenen Feld des Magneten eines MR-Tomographiegerätes mit einem Spulenrohr, an dessen Wand die Gradientenspulen befestigt sind.

Aus der WO 86/07459-Patentanmeldung ist es bekannt, Gradientenspulen innerhalb des Magnetfeldes eines Nuclear-Magnetic-Resonance-(NMR)-Diagnosegerät auf einem Spulenrohr zu befestigen, das seinerseits an der Magnetinnenwand befestigt ist. Durch das Befestigen des Spulenrohres an der Magnetinnenwand werden die Betriebsschwingungen der Gradientenspulen auf die Magnetspulen des MR-Tomographen übertragen. Außerdem belastet das Eigengewicht der Gradientenspulen-Anordnung die Magnetspule. Da keine Schwingungssicherung vorhanden ist, ist eine genaue Positionierung der Gradientenspulen auf dem Spulenrohr bzw. innerhalb des Magneten nicht möglich.

Es ist Aufgabe der Erfindung, eine Vorrichtung der eingangs erwähnten Art zu schaffen, bei der mechanische Schwingungsübertragungen der Gradientenspulen auf den Magneten vermieden werden und mittels der die Gradientenspulen innerhalb des homogenen Feldes des Magneten einwandfrei justierbar sind.

Die gestellte Aufgabe ist erfindungsgemäß dadurch gelöst, daß das Spulenrohr mit den Gradientenspulen ohne Abstützung innerhalb des Magneten angeordnet ist und justierbar von einem Traggestell getragen wird, das sich außerhalb des Magneten befindet.

Durch die justierbare Abstützung des Spulenrohres an einem Gestell, welches sich außerhalb des Magneten befindet, ist eine vollkommene mechanische Entkopplung zwischen den Gradientenspulen und dem Magneten erreicht. Gegenseitige mechanische Schwingungsbeeinflussungen sind damit ausgeschaltet.

Nach einer weiteren Ausgestaltung der Erfindung ist vorgesehen, daß das Gestell ein sich durch den Magneten erstreckendes Trägerrohr trägt, in dem mittels ringförmiger Spann- und Justiervorrichtungen das Spulenrohr mit den Gradientenspulen gehalten ist. Das Traggestell und das Trägerrohr bilden zusammen ein Traggerüst für das Spulenrohr mit den Gradientenspulen. Eine feine Justierung läßt sich dann innerhalb des Magneten zwischen dem Trägerrohr und dem Spulenrohr herbeiführen.

Nach einer weiteren Ausgestaltung der Erfindung ist vorgesehen, daß das Trägerrohr mit einer unteren, am Traggestell befestigten Halbschale und einer oberen, an der unteren Halbschale befestigten Halbschale gehalten wird. Das Trägerrohr verbindet in diesem Fall die beiden Traggestelle durch den Magneten hindurch, so daß es zunächst in seiner Lage gegenüber dem Magneten justiert werden kann. Die obere Halbschale dient dann dazu, das Spulenrohr auf der unteren justierten Halbschale festzulegen.

Nach einer weiteren Ausgestaltung der Erfindung ist vorgesehen, daß zwei äußere und eine mittlere Spann- und Justiervorrichtung vorgesehen sind. Zwei äußere und eine mittlere Spann- und Justiervorrichtung bieten Gewähr für eine exakte Halterung des Spulenrohres innerhalb des Trägerrohres. Die Einspannung und Justierung selbst erfolgt nach einer weiteren Ausgestaltung der Erfindung dadurch, daß jede der Spann- und Justiervorrichtungen axial geteilt ist in einen inneren Ringteil und äußere Keilteile, wobei die Teilungsflächen zwischen den Teilen keilförmig verlaufen. Durch gegenseitiges Verschieben von Keilen und Ringteilen längs der keilförmigen Teilungsflächen erfolgt die Verspannung und Justierung.

In weiterer Ausgestaltung der Erfindung ist dabei vorgesehen, daß die innen gelegenen Ringteile der Spann- und Justiervorrichtungen mittels Stehbolzen am Spulenrohr befestigt sind. Die außen gelegenen Keilteile lassen sich dann gegenüber den innen gelegenen Ringteilen axial verspannen. Hierzu ist vorgesehen, daß dem Verspannen Keilschrauben dienen, die axial durch Gewindebohrungen der Stehbolzen geführt sind und mit denen die Keilteile axial gegenüber den Ringteilen verstellbar sind. Obwohl das Trägerrohr sicher am Erdboden abgestützt ist und das Spulenrohr innerhalb des Trägerrohres fest verspannt und justiert ist, ist immer noch die Möglichkeit gegeben, daß die Gradientenspulen innerhalb des Spulenrohres mechanische Eigenschwingungen ausführen. Um dies zu vermeiden, ist nach einer weiteren Ausgestaltung der Erfindung vorgesehen, daß Klemmleisten vorgesehen sind, die sich axial über die Gradientenspulen erstrecken und axial beiderseits von ihnen mit dem Spulenrohr fest verbunden sind. Die Klemmleisten drücken die Gradientenspulen fest gegen das Spulenrohr und verhindern damit deren mechanische Schwingungen.

Die Erfindung wird anhand der Zeichnung näher erläutert. Es zeigen:

Fig. 1 eine Vorrichtung zum Anordnen von Gradientenspulen im homogenen Feld eines 4-Tesla-Magneten, wobei die Gradientenspulen außerhalb des Magneten von einem Traggestell getragen werden,

Fig. 2 eine Seitenansicht der Vorrichtung nach Fig. 1,

Fig. 3 eine vergrößerte Detailansicht des strichpunktiert umrahmten Teiles der Vorrichtung nach Fig. 1,

Fig. 4 eine Seitenansicht der Spann- und Justiervorrichtungen,

Fig. 5 eine Klemmleiste zum radialen Verspannen der Gradientenspulen gegenüber ihrem Spulenrohr.

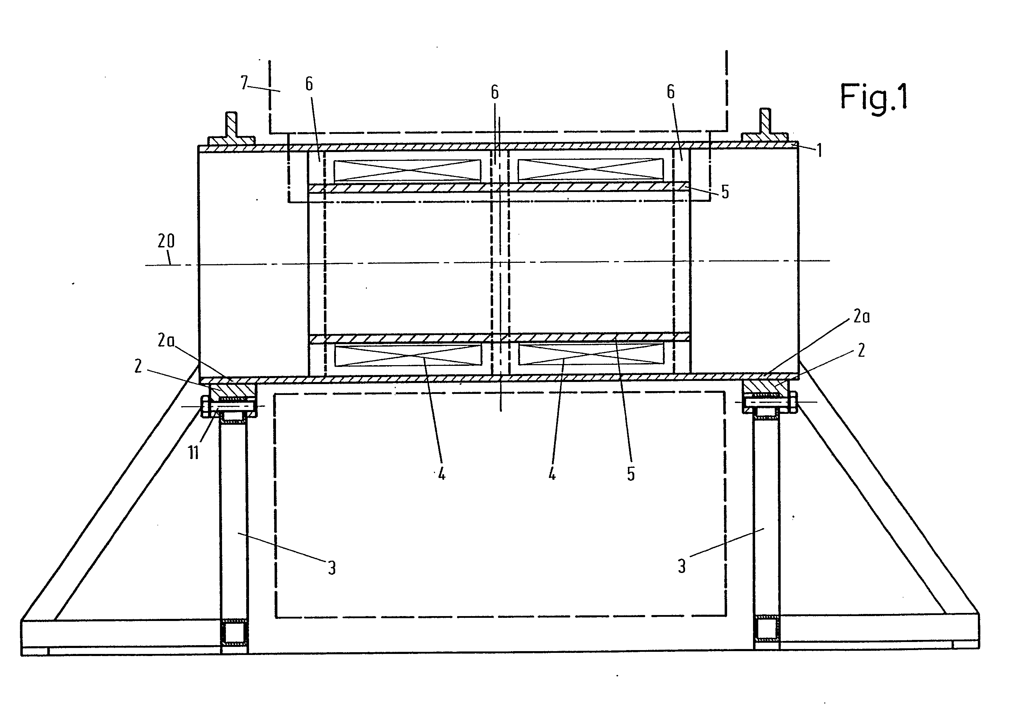

Die in Fig. 1 teilweise im Schnitt dargestellte Vorrichtung zum Anordnen von Gradientenspulen im homogenen Feld eines 4-Tesla-Magneten besteht aus einem Kunststoffträgerrohr 1, das mittels justierbarer Stellvorrichtungen 2 an seinen Enden 2a an zwei Traggestellen 3 abgestützt ist. Zwei Gradientenspulen 4 sind auf einem Spulenrohr 5 auf noch näher zu beschreibende Weise befestigt mit Hilfe von Spann- und Justiervorrichtungen 6. Das Trägerrohr durchgreift berührungsfrei einen 4-Tesla-Magneten 7, der nur gestrichelt angedeutet ist.

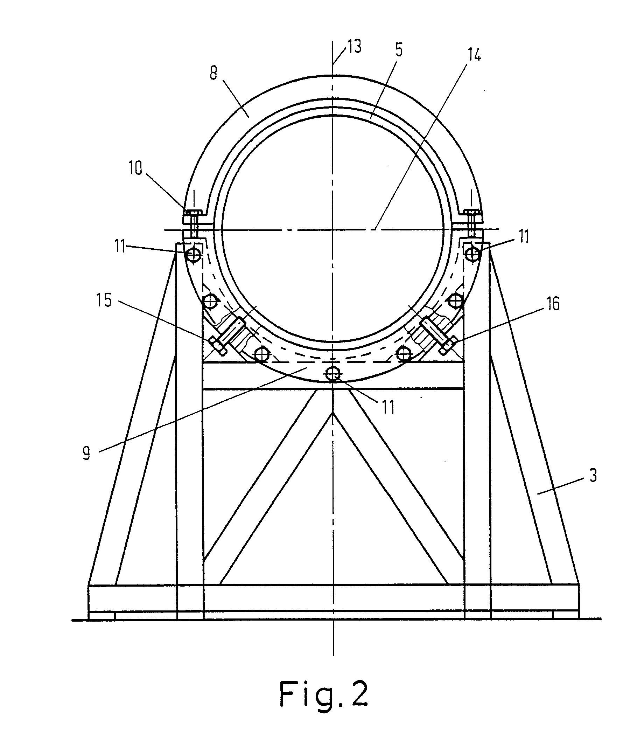

Fig. 2 zeigt anhand einer Seitenansicht, daß das Trägerrohr 1 mit einer oberen Halbschale 8 und einer unteren Halbschale 9 befestigt wird. Beide Halbschalen 8 und 9 sind mittels Spannschrauben 10 gegeneinander gezogen. Die untere Halbschale 9 ist mit Hilfe von Schrauben 11 mit dem Gestell 3 verbunden. Die Justierung des Trägerrohres 1 mit seinen Radialachsen 13 und 14 gegenüber dem Gestell 3 erfolgt mit Hilfe von Druckschrauben 15 und 16.

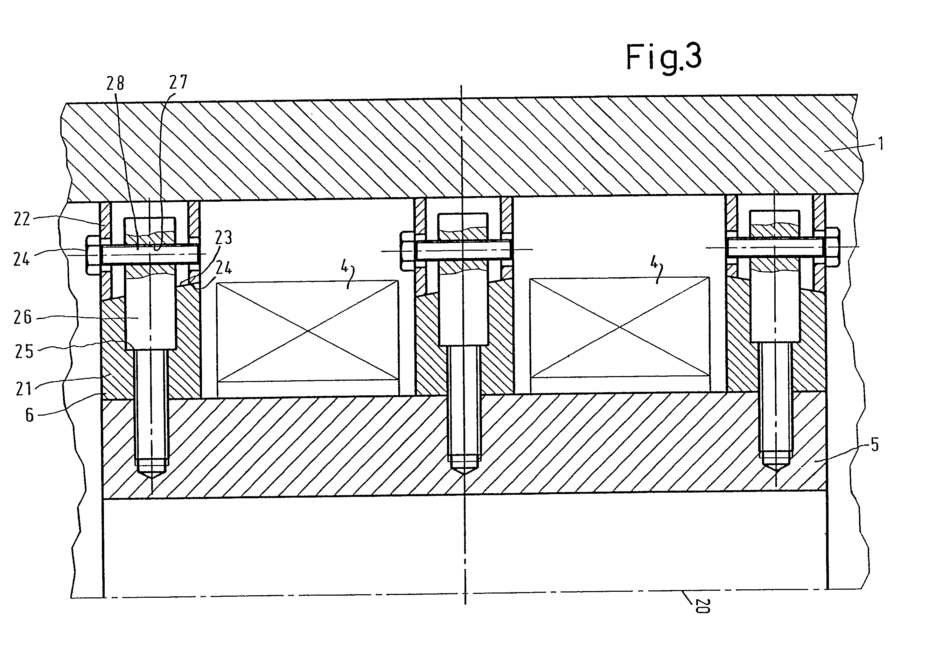

Fig. 3 zeigt die gegenseitige Justierung des Spulenrohres gegenüber dem Trägerrohr 1. Beide Rohre sind koaxial zu einer gemeinsamen Rotationsachse miteinander verbunden mit Hilfe der Spann- und Justiervorrichtungen 6, die jeweils aus einem inneren Ringteil 21 und äußeren Keilteilen 22 besteht. Die Keilteile 22 und die Ringteile 21 weisen korrespondierende Keilflächen 23, 24 auf. Die Keilteile 22 mit ihren Keilflächen 24 sind dabei gegenüber den Ringteilen 21 axial verschiebbar zum Justieren und Verspannen. Die Ringteile 21 sind mit Hilfe von Stehbolzen in dem Spulenrohr 5 festgeschraubt. Diese Schrauben verlaufen radial. Senkrecht durch Köpfe 26 der Stehbolzen sind durch axiale Gewindebohrungen 27 der Köpfe 26 Keilschrauben 28 hindurchgeführt. Durch ein Verdrehen der Keilschrauben erfolgt ein gegenseitiges Verschieben von inneren Ringteilen 21 und Keilteilen 21 bis zu einem vollständigen Verspannen.

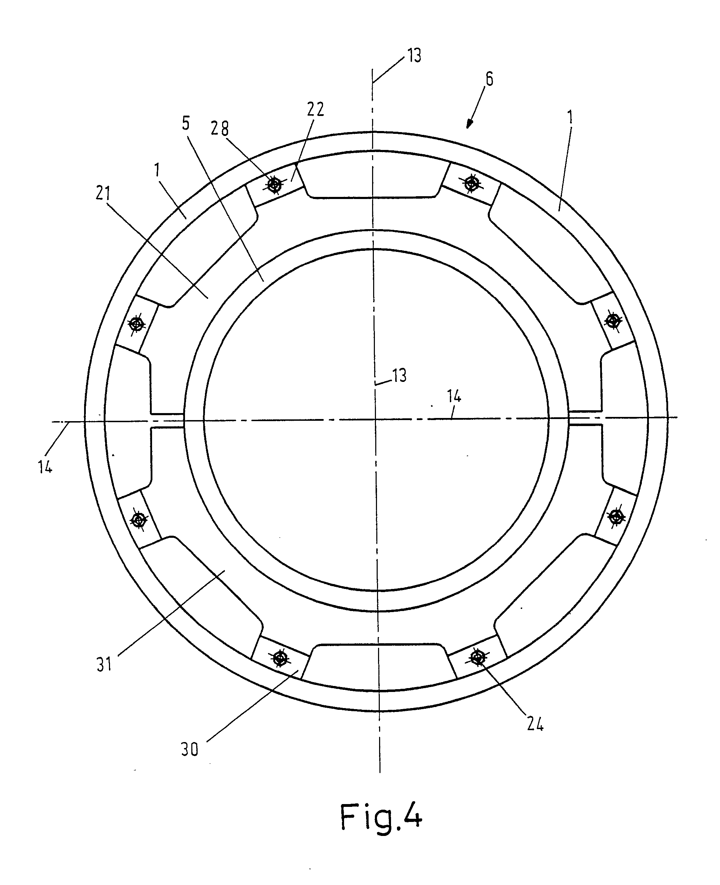

Fig. 4 zeigt eine Justier- und Spannvorrichtung 6 in Seitenansicht. Man erkennt den auf dem Spulenrohr 5 aufsetzenden inneren Ringteil 21 und die Keilteile 22, die mit Hilfe der Keilschrauben 28 gegenüber dem Trägerrohr 1 verspannbar sind. Die Justierung erfolgt durch wechselseitiges Lösen und Festziehen der Keilschrauben 28. Dadurch werden die Keilteile 22 gegenüber dem Ringteil 21 verschoben, bis die richtige Justierung herbeigeführt ist.

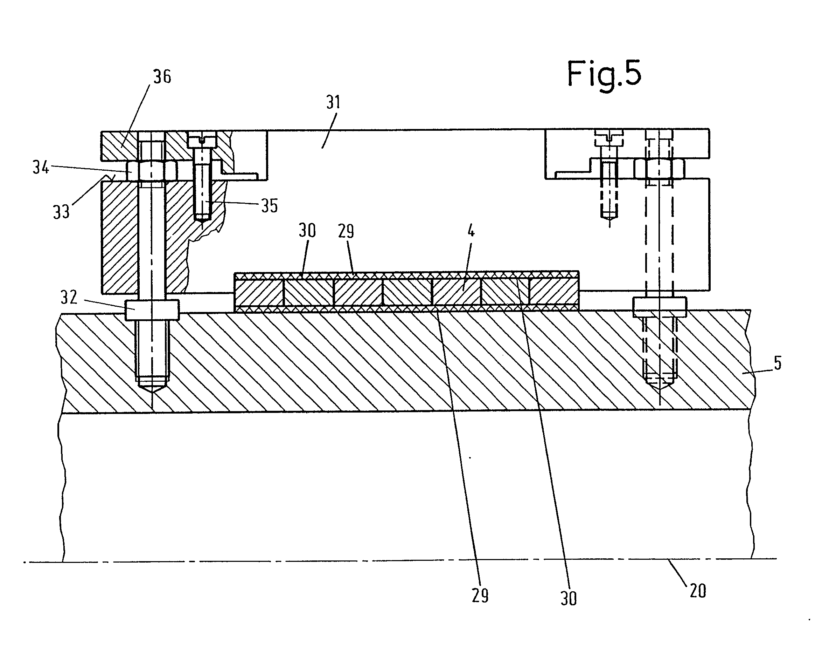

Fig. 5 zeigt eine Gradientenspule im Schnitt, die gegenüber dem Spulenrohr 5 mit einer elastischen Zwischenlage 29 abgefedert ist. Gegen die Außenseite 30 der Gradientenspule wird eine Klemmleiste 31 gedrückt, wieder unter Zwischenschaltung einer elastischen Zwischenlage 29. Die Klemmleiste 31 erstreckt sich parallel zur Rotationsachse 20. In das Spulenrohr 5 sind Stehbolzen 32 eingeschraubt, die sich radial durch die Klemmleisten 31 erstrecken. Gegen eine ebenfalls parallel zur Rotationsachse verlaufende Einschnittkante 33 ist eine Klemm-Mutter 34 schraubbar. Diese Klemm-Mutter drückt die Klemmleiste 31 gegen die Gradientenspule 4 und diese damit gegen das Spulenrohr 5. Die Klemmleiste 31 wird durch Anziehen einer radial verlaufenden Spannschraube 35 starr mit einem Spannelement 36 gekoppelt, das seinerseits gegen die Klemm-Mutter 34 drückt, um diese an einem Lockern zu hindern.

## Ansprüche

1. Vorrichtung zum Anordnen von Gradientenspulen (4) im homogenen Feld des Magneten (7) eines MR-Tomographiegerätes mit einem Spulenrohr (5), an dessen Wand die Gradientenspulen (4) befestigt sind, dadurch gekennzeichnet, daß das Spulenrohr (5) mit den Gradientenspulen (4) ohne Abstützung innerhalb des Magneten (7) angeordnet ist und justierbar von einem Traggestell (3) getragen wird, das sich außerhalb des Magneten (7) befindet.

2. Vorrichtung nach Anspruch 1, dadurch gekennzeichnet, daß das Gestell (3) ein sich durch den Magneten (7) erstreckendes Trägerrohr (1) trägt, in dem mittels ringförmiger Spann- und Justiervorrichtungen (6) das Spulenrohr (5) mit den Gradientenspulen (4) gehalten ist.

3. Vorrichtung nach Anspruch 1 oder 2, dadurch gekennzeichnet, daß das Trägerrohr (1) mit einer unteren, am Traggestell (3) befestigten Halbschale (9) und einer oberen, an der unteren Halbschale befestigten Halbschale (8) befestigt ist.

4. Vorrichtung nach Anspruch 1, dadurch gekennzeichnet, daß zwei äußere und eine mittlere Spann- und Justiervorrichtung (6) vorgesehen sind.

5. Vorrichtung nach Anspruch 1 oder 4, dadurch gekennzeichnet, daß jede der Spann- und Justiervorrichtungen (6) axial geteilt ist in einen inneren Ringteil (21) und äußere Keilteile (22), wobei die Teilungsflächen (23, 24) zwischen den Teilen keilförmig verlaufen.

6. Vorrichtung nach Anspruch 2, dadurch gekennzeichnet, daß die innen gelegenen Ringteile (21) der Spann- und Justiervorrichtungen (6) mittels Stehbolzen (25) am Spulenrohr (5) befestigt sind.

7. Vorrichtung nach Anspruch 5, dadurch gekennzeichnet, daß die außen gelegenen Keilteile (22) axial gegenüber den innen gelegenen Ringteilen (21) verspannbar sind.

8. Vorrichtung nach Anspruch 1, dadurch gekennzeichnet, daß dem Verspannen Keilschrauben (24) dienen, die axial durch Gewindebohrungen (27) der Stehbolzen (25) geführt sind.

9. Vorrichtung nach Anspruch 1, dadurch gekennzeichnet, daß Klemmleisten (31) vorgesehen sind, die sich axial über die Gradientenspulen (4) erstrecken und axial beiderseits von ihnen mit dem Spulenrohr (5) fest verbunden sind.

Fig.1

Fig.2

Fig.3

Fig.4

Fig.5

EP 0 362 931 A2